# EUROPEAN PATENT APPLICATION

(11) **EP 4 541 931 A1**
(43) Date of publication of application: **23.04.2025**
(21) Application number: 24168732.6
(22) Date of filing: 05.04.2024
(51) Int. Cl.: C23C 16/44, C23C 16/455, C30B 25/08

(54) **CEILING PLATE AND EPITAXIAL GROWTH DEVICE HAVING THE SAME**

(30) Priority: 20.10.2023 TW 112140310
(71) Applicant: Taiwan-Asia Semiconductor Corporation, Hsinchu City 30078 (TW)
(72) Inventor: CHANG, Yao-Song, 30078 Hsinchu City (TW); HSIEH, Po-Jen, 30087 Hsinchu City (TW)
(74) Representative: Michalski Hüttermann & Partner Patentanwälte mbB

(57) **Abstract**

A ceiling plate and an epitaxial growth device having the same are provided. The epitaxial growth device includes a wafer carrying platform and a reaction chamber. The wafer carrying platform is used to carry at least one wafer, and the reaction chamber accommodates the wafer carrying platform and includes a ceiling plate and a gas supply device. The ceiling plate is disposed on the top of the reaction chamber, and the gas supply device provides a reaction gas to at least one wafer on the wafer carrying platform. The ceiling plate includes a plurality of recessed structures so that when the reaction gas flows through the recessed structures, the friction resistance with the surface of the ceiling plate is reduced.

## Description

### CROSS-REFERENCES TO RELATED APPLICATIONS

This application claims the benefit of priority to Taiwanese Patent Application No. 112140310 filed on October 20, 2023, which is hereby incorporated by reference in its entirety.

### BACKGROUND OF THE INVENTION

### Field of the Invention

The present invention relates to a semiconductor growth device, in particular to an epitaxial growth device.

### Descriptions of the Related Art

The demand for semiconductor epitaxial materials is becoming more and more widespread. Typical group III-V compound semiconductors such as gallium nitride can be used in light emitting diodes and power devices. Semiconductor epitaxial materials can be grown in many different ways, including molecular beam epitaxy (MBE), hydride vapor phase epitaxy (HVPE), and metal-organic chemical vapor deposition (Metal-organic Chemical Vapor Deposition, MOCVD), etc. Among them, the MOCVD reactor is the best equipment for producing epitaxial films with sufficient quality for group III-V compound semiconductors.

The MOCVD reactor includes a reaction chamber. A rotatable wafer tray is provided at the bottom of the reaction chamber. Wafers waiting for being processed are placed on the wafer tray. An air supply device is equipped in the upper area inside the reaction chamber. The reaction gas flowing in from the gas supply device flows to the wafer placed on the upper surface of the tray, and grows the required epitaxial film on the upper surface of the wafer.

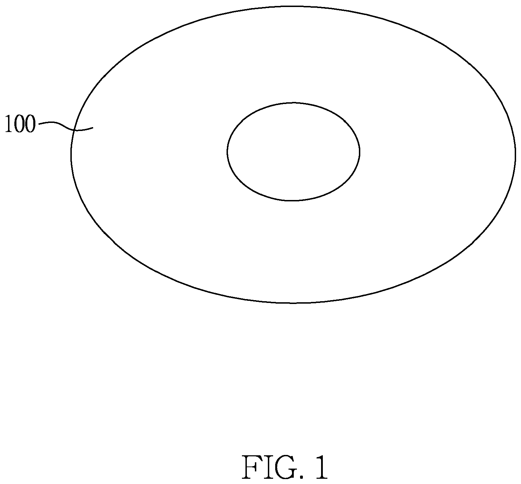

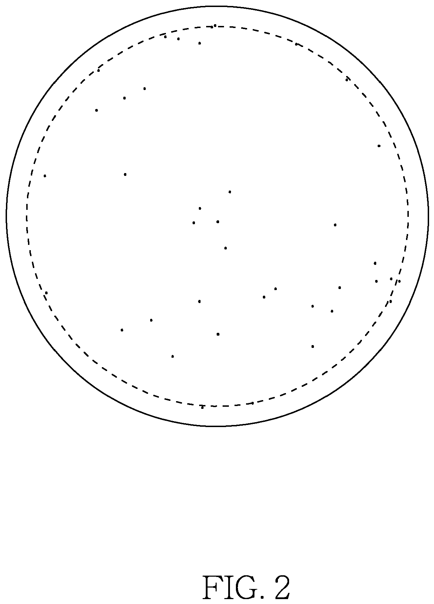

However, while using the MOCVD process to form an epitaxial film on the wafer surface, some residual deposits remain on the inner wall of the reaction chamber and the surface of the gas nozzle, etc. These residual deposits can create impurities in the reaction chamber. For example, it is easy for deposits to adhere to the ceiling 100 with a smooth top surface of the reaction chamber as shown in FIG. 1 (note: the inner ring of the ceiling as shown in FIG. 1 is the gas supply area). In subsequent processes, residual deposits may peel off from their adhering points due to the factors such as gravity or air flow. Eventually they will fall on the processing wafer and cause defects generated on the films of the wafer. As shown in FIG. 2, the defects came from the residual deposits affects the electrical properties of the final compound semiconductors and reduces the production yield. In view of this, a common response in the industry is to suspend the operation of the MOCVD equipment after a certain production period. A reaction chamber cleaning procedure will be performed to remove residual deposits from the reaction chamber. However, the MOCVD equipment must be cooled down before cleaning, which takes a lot of time and thus reduces production capacity. In order to overcome the above problems, the industry urgently needs an innovative epitaxial growth device to improve the above problems.

### SUMMARY OF THE INVENTION

The main objective of the present invention is to provide an innovative epitaxial growth device. A plurality of recessed structures are provided on the ceiling plate of the epitaxial growth device to reduce the chance of deposits adhering to the surface of the ceiling plate during the epitaxial growth process. At the same time, it also reduces the chance that residual deposits attached to the ceiling plate will subsequently peel off due to factors such as gravity or air flow and contaminate the wafer.

To achieve the above objective, the present invention discloses an epitaxial growth device. The epitaxial growth device includes a wafer carrying platform and a reaction chamber. The wafer carrying platform is used to carry at least one wafer, and the reaction chamber accommodates the wafer carrying platform and includes a ceiling plate and a gas supply device. The ceiling plate is disposed on the top of the reaction chamber, and the gas supply device provides a reaction gas to at least one wafer on the wafer carrying platform. The ceiling plate includes a plurality of recessed structures so that when the reaction gas flows through the recessed structures, the friction resistance with the surface of the ceiling plate is reduced.

In one embodiment of the epitaxial growth device of the present invention, a recessed depth of each of the recessed structures ranges from 0.2 millimeters to 2 millimeters.

In one embodiment of the epitaxial growth device of the present invention, a diameter of each of the recessed structures ranges from 0.2 millimeters to 25 millimeters.

In one embodiment of the epitaxial growth device of the present invention, a spacing between each of the recessed structures is not greater than the diameter of each of the recessed structures.

In one embodiment of the epitaxial growth device of the present invention, each of the recessed structures is one of a bowl-shaped structure, a cone-shaped structure, a quadrangular structure, a trapezoid-shaped structure, and a polygon-shaped structure.

In one embodiment of the epitaxial growth device of the present invention, the recessed structures are arranged in one of a radial layout, a concentric circle layout, a spiral layout in the ceiling plate.

In one embodiment of the epitaxial growth device of the present invention, the ceiling plate is made of graphite, quartz and graphite with silicon carbide layers thereon.

To achieve the above objective, the present invention discloses a ceiling plate applied in an epitaxial growth device. The epitaxial growth device comprises a reaction chamber for providing a reaction gas and the ceiling plate is disposed on the top of the reaction chamber. The ceiling plate is characterized by the ceiling plate includes a plurality of recessed structures so that when the reaction gas flows through the recessed structures, the friction resistance with the surface of the ceiling plate is reduced.

In one embodiment of the ceiling plate of the present invention, a recessed depth of each of the recessed structures ranges from 0.2 millimeters to 2 millimeters.

In one embodiment of the ceiling plate of the present invention, a diameter of each of the recessed structures ranges from 0.2 millimeters to 25 millimeters.

In one embodiment of the ceiling plate of the present invention, a spacing between each of the recessed structures is not greater than the diameter of each of the recessed structures.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1 is a schematic diagram of the structure of the ceiling plate in a conventional epitaxial growth device;
FIG. 2 is a schematic diagram of the distribution of defects on the wafer surface after epitaxial growth using the conventional epitaxial growth device;
FIG. 3 is a schematic diagram of the structure of the epitaxial growth device in one embodiment of the present invention;
FIG. 4 is a partial exploded view of the epitaxial growth device in one embodiment of the present invention;
FIG. 5 is a schematic diagram of the structure of the ceiling plate in the epitaxial growth device in one embodiment of the present invention;
FIG. 6 is a schematic diagram of airflow between the ceiling plate and the wafer in the epitaxial growth device in one embodiment of the present invention;
FIG. 7 is a schematic diagram showing the reduction of defects on the wafer surface after epitaxial growth using the epitaxial growth device of the present invention;
FIG. 8 is a sectional schematic diagram of recessed structures on the ceiling plate in several embodiments of the present invention;
FIG. 9 is a schematic diagram showing the distribution of multiple recessed structures on the ceiling plate in one embodiment of the present invention;
FIG. 10 is a schematic diagram showing different arrangements of multiple recessed structures on the ceiling plate in several embodiments of the present invention;
FIG. 11 is a schematic diagram showing the design of different distributions of recessed structures on the ceiling plate in two embodiments of the present invention;
FIG. 12 is a schematic diagram showing the distribution of multiple recessed structures on the ceiling plate in several embodiments of the present invention; and
FIG. 13 is a schematic diagram showing the distribution of multiple recessed structures on the ceiling plate in several embodiments of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

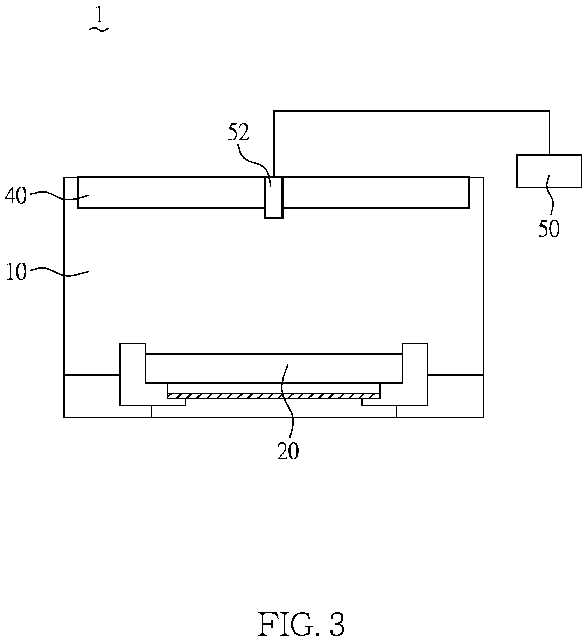

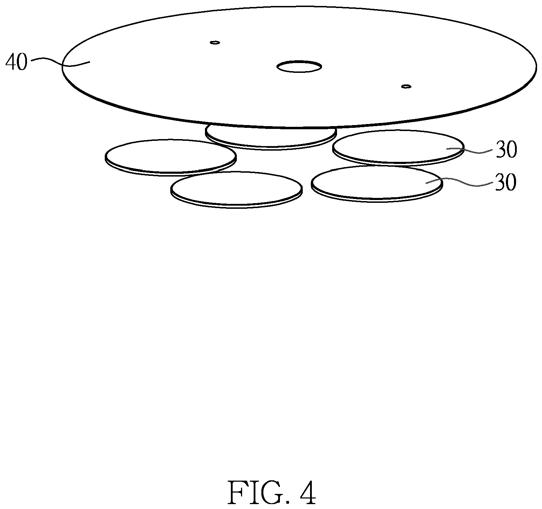

Please refer to FIG. 3 and FIG. 4. FIG. 3 is a schematic diagram of an embodiment of the epitaxial growth device of the present invention, and FIG. 4 is a partial exploded view of the epitaxial growth device in one embodiment of the present invention. As shown in the embodiments, the epitaxial growth device 1 of the present invention comprises a reaction chamber 10 and a wafer carrying platform 20. The wafer carrying platform 20 is used to carry at least one wafer 30 to be processed. The reaction chamber 10 has a space defined by enclosed side walls to accommodate the wafer carrying platform 20. The reaction chamber 10 further comprises a ceiling plate 40 and a gas supply device 50. The ceiling plate 40 is disposed on the top end of the side wall of the reaction chamber 10, and can be made of one of graphite, quartz, or graphite with a silicon carbide layer on the surface. The gas supply device 50 provides reaction gas to the reaction chamber 10 through a gas supply pipeline and an outlet 52 for allowing the wafer 30 to be processed on the wafer carrying platform 20 to undergo epitaxial growth, such as III-V compound epitaxial growth.

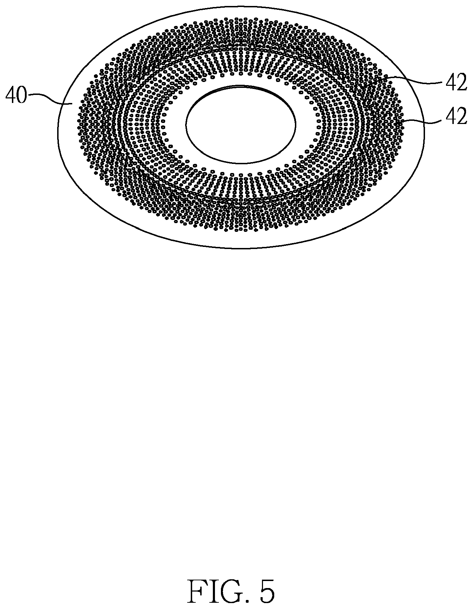

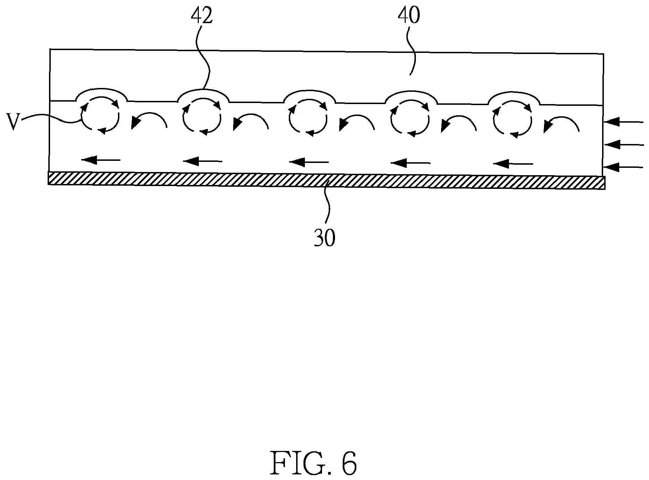

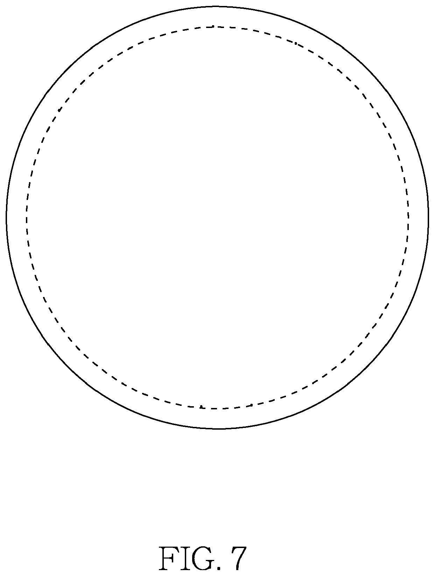

Please refer to FIG. 5, which shows a schematic diagram of the structure of the ceiling plate 40 in an embodiment of the present invention. One feature of the epitaxial growth device 1 of the present invention is that the ceiling plate 40 includes a plurality of recessed structures 42. Each recessed structure 42 has a specific size of recess and extends a specific depth recessed from the surface of the ceiling plate 40. In preferred embodiments, the diameter of each recessed structure 42 is approximately between 0.2 millimeters and 25 millimeters, and the recessed depth of each recessed structure 42 is approximately between 0.2 millimeters and 2 millimeters. Moreover, the spacing between each recessed structure 42 is not greater than the diameter of each recessed structure 42. That is, the spacing between each recessed structure 42 is substantially between 0.2 millimeters and 25 millimeters. Please refer to FIG. 6, which shows a schematic diagram of the airflow between the ceiling plate 40 and the wafer 30 in an embodiment of the present invention. In the schematic diagram, arrows represent the direction of airflow only used to illustrate the technical features of the ceiling plate of the present invention rather than the actual direction and strength of airflow. As shown in FIG. 6, when the reaction gas flows into the reaction chamber 10 from the outlet 52 of the gas supply device 50, small vortices V (vortex) are formed inside the recessed structures 42 as the airflow passes therethrough and cause the airflow on the surface of the ceiling plate 40 to effectively "skip over" the recessed structures. Thus, the friction resistance with the surface of the ceiling plate will be reduced accordingly. In other words, the airflow in the boundary layer on the surface of the ceiling plate 40 is relatively "slippery" for reducing the friction resistance between the reaction gas and the surface of the ceiling plate as it passes through each recessed structure 42. Therefore, the chance of deposits adhering to the surface of the ceiling plate 40 will be reduced. Moreover, the chance of residual deposits originally adhered to the ceiling plate subsequently peeling off due to factors such as gravity or airflow and contaminating the wafer will be reduced as well. As shown in FIG. 7, it illustrates the epitaxial growth device with a ceiling plate containing recessed structures disclosed herein. The defect contamination on the surface of the wafer after the epitaxial growth process caused by the peeling off of residual deposits on the top plate has been substantially reduced compared to the surface of the wafer produced by the conventional process shown in FIG. 2.

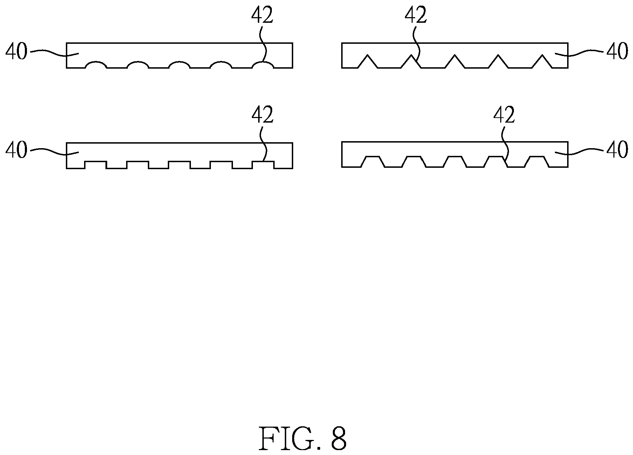

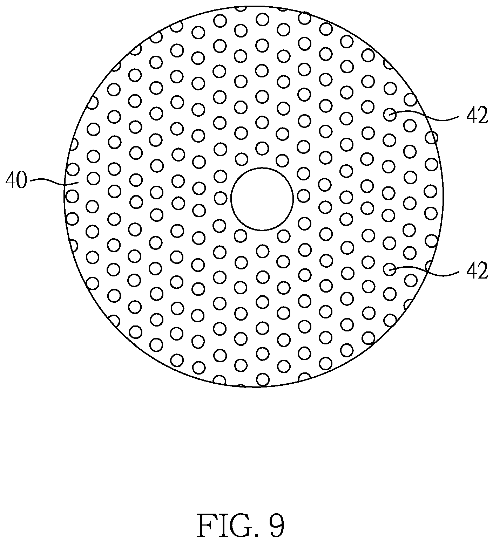

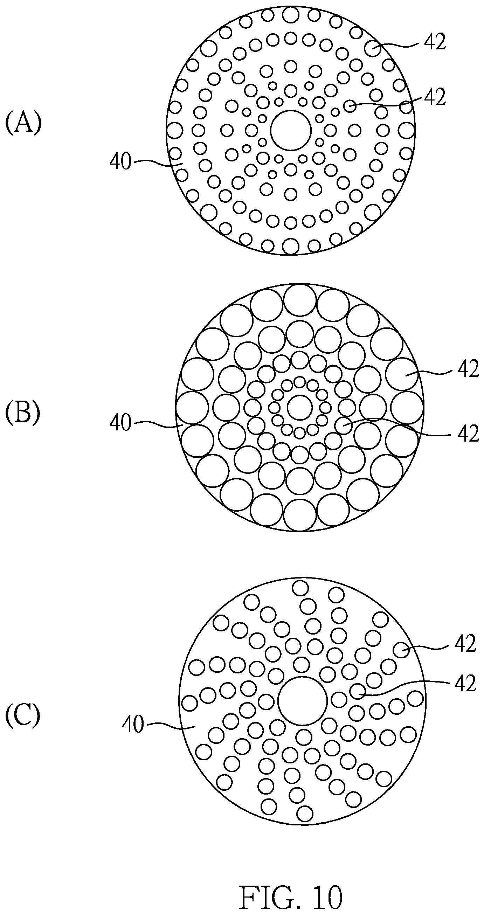

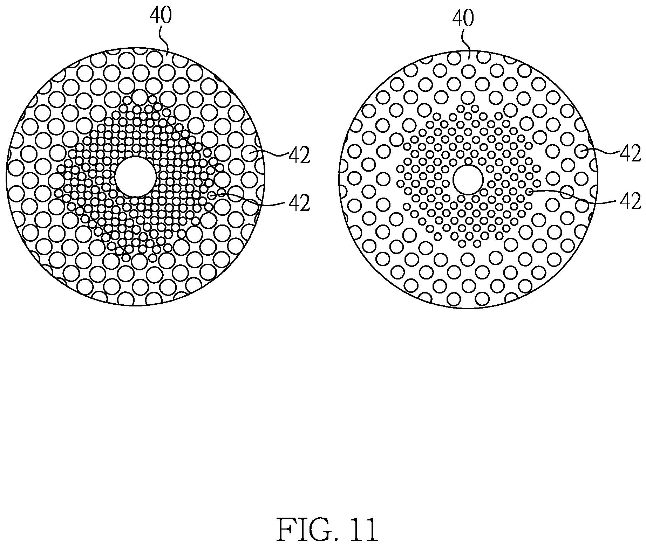

As mentioned above, in order to reduce the chance of reaction gas forming deposits on the surface of the ceiling plate 40, the present invention discloses the design of several different recessed structures on the ceiling plate in the epitaxial growth device. Please refer to FIG. 8, which shows a schematic diagram of the cross-section of recessed structures 42 on the ceiling plate in various embodiments of the present invention. These recessed structures 42 can be, but not limited to, bowl-shaped structures, cone-shaped structures, quadrangular structures, trapezoid-shaped structures, polygon-shaped structures, or combinations thereof. Any recessed structure design that can reduce the adhesion of reaction gas to the surface of the ceiling plate is within the scope of the present invention. Additionally, please refer to FIG. 9 and FIG. 10, where FIG. 9 shows a schematic diagram of the distribution of a plurality of recessed structures 42 on the ceiling plate in an embodiment of the present invention. In this embodiment, the spacing between each of the recessed structures 42 on the ceiling plate 40 is not greater than the diameter of each of the recessed structures 42 and they are evenly distributed on the ceiling plate 40 with substantially the same spacing. On the other hand, FIG. 10 further illustrates the distribution of multiple recessed structures 42 in different arrangements on the ceiling plate in various embodiments of the present invention. These recessed structures 42 on the ceiling plate 40 can be arranged in, for example, but not limited to, a radial layout arrangement as shown in FIG. 10(A), a concentric circle layout arrangement as shown in FIG. 10(B), a spiral layout arrangement as shown in FIG. 10(C), or combinations thereof. Particularly, as shown in FIG. 10(B) and FIG. 10(C), different diameter recessed structures 42 can be distributed on the ceiling plate 40, depending on the actual airflow conditions within the reaction chamber 10 of the epitaxial growth device 1, to effectively reduce the residual deposition of reaction gas on the surface of the ceiling plate 40. For example, as shown in FIG. 11, it illustrates two different distribution designs of recessed structures on the ceiling plate, which can be divided into different areas on the ceiling plate surface. For instance, from the center of the outlet, recessed structures of different sizes (e.g., from small to large) and different spacing (e.g., from dense to sparse) can be arranged to reduce the residual deposition of reaction gas on the surface of the ceiling plate 40.

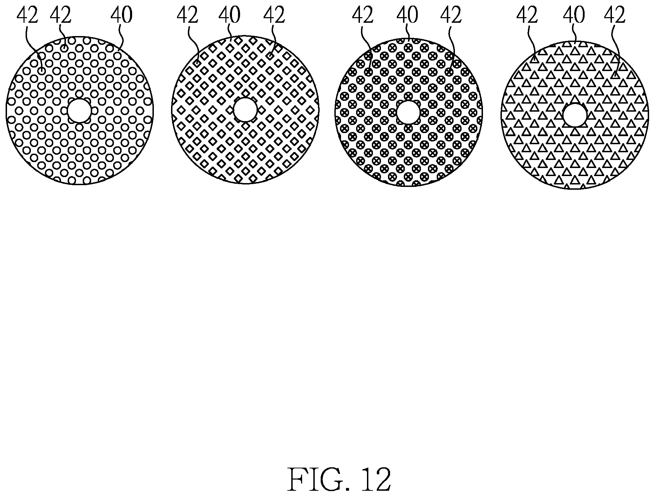

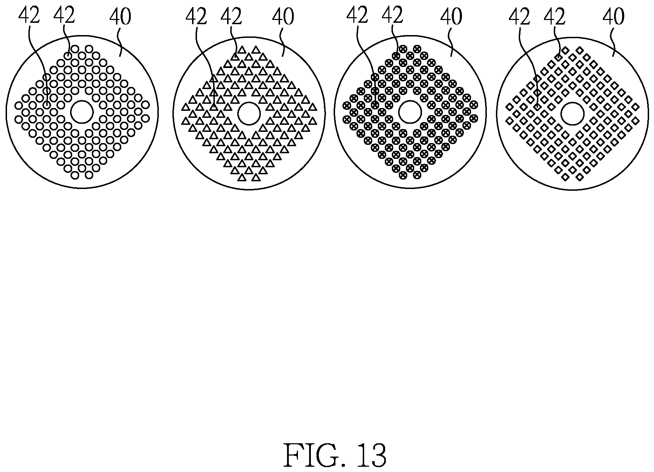

Please refer to FIG. 12 and FIG. 13 together. FIG. 12 illustrates a schematic diagram of the distribution of multiple recessed structures 42 on the ceiling plate 40 in several embodiments of the present invention. In this embodiment, the recessed structures 42 on the ceiling plate 40 of the present invention can adopt different cross-sectional structures as shown in FIG. 8, for example, but not limited to, bowl-shaped structures, quadrangular structures, cone-shaped structures, triangular structures, and are arranged on the ceiling plate 40 in a substantially uniform manner. On the other hand, as shown in FIG. 13, the ceiling plate in several embodiments of the present invention can selectively arrange and distribute different recessed structures 42 only in specific areas based on the actual airflow conditions inside the reaction chamber of the epitaxial growth device.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. An epitaxial growth device, comprising:
a wafer carrying platform, used to carry at least one wafer; and
a reaction chamber, used to accommodate the wafer carrying platform, the reaction chamber including a ceiling plate and a gas supply device, the ceiling plate disposed on the top of the reaction chamber, and the gas supply device providing a reaction gas to the at least one wafer on the wafer carrying platform,
wherein the ceiling plate includes a plurality of recessed structures so that when the reaction gas flows through the recessed structures, the friction resistance with the surface of the ceiling plate is reduced.

2. The epitaxial growth device of the previous claim, wherein a recessed depth of each of the recessed structures ranges from 0.2 millimeters to 2 millimeters.

3. The epitaxial growth device of any of the previous claims, wherein a diameter of each of the recessed structures ranges from 0.2 millimeters to 25 millimeters.

4. The epitaxial growth device of the previous claim, wherein a spacing between each of the recessed structures is not greater than the diameter of each of the recessed structures.

5. The epitaxial growth device of any of the previous claims, wherein each of the recessed structures is one of a bowl-shaped structure, a cone-shaped structure, a quadrangular structure, a trapezoid-shaped structure, and a polygon-shaped structure.

6. The epitaxial growth device of any of the previous claims, wherein the recessed structures are arranged in one of a radial layout, a concentric circle layout, a spiral layout in the ceiling plate.

7. The epitaxial growth device of any of the previous claim, wherein the ceiling plate is made of graphite, quartz and graphite with silicon carbide layers thereon.

8. A ceiling plate applied in an epitaxial growth device, wherein the epitaxial growth device comprises a reaction chamber for providing a reaction gas and the ceiling plate is disposed on the top of the reaction chamber, the ceiling plate is **characterized by**:
the ceiling plate including a plurality of recessed structures so that when the reaction gas flows through the recessed structures, the friction resistance with the surface of the ceiling plate is reduced.

9. The ceiling plate applied in an epitaxial growth device of the previous claim, wherein a recessed depth of each of the recessed structures ranges from 0.2 millimeters to 2 millimeters.

10. The ceiling plate applied in an epitaxial growth device of any of the previous two claims, wherein a diameter of each of the recessed structures ranges from 0.2 millimeters to 25 millimeters.

11. The ceiling plate applied in an epitaxial growth device of the previous claim, wherein a spacing between each of the recessed structures is not greater than the diameter of each of the recessed structures.
